# EUROPEAN PATENT APPLICATION

(11) **EP 4 697 604 A1**
(43) Date of publication of application: **18.02.2026**
(21) Application number: 24795767.3
(22) Date of filing: 29.03.2024
(51) Int. Cl.: H03M 7/30

(54) **DATA COMPRESSION METHOD AND APPARATUS, COMPUTER DEVICE, AND STORAGE MEDIUM**

(30) Priority: 26.04.2023 CN 202310475629
(71) Applicant: Huawei Technologies Co., Ltd., Shenzhen, Guangdong 518129 (CN)
(72) Inventor: WU, Chengda, Shenzhen, Guangdong 518129 (CN); HUANG, Yongbing, Shenzhen, Guangdong 518129 (CN)
(74) Representative: Gill Jennings & Every LLP
(86) International application number: PCT/CN2024/084949
(87) International publication number: WO 2024/222386

(57) **Abstract**

Embodiments of this application disclose a data compression method and apparatus, a computer device, and a storage medium, and belong to the field of data storage technologies. The method includes: obtaining a to-be-compressed data stream, where the data stream includes a plurality of pieces of data; determining a plurality of types of data from the plurality of pieces of data based on context information of each of the plurality of pieces of data, where each of the plurality of types of data includes at least one of the plurality of pieces of data, and the context information of each piece of data indicates data before and/or after corresponding data in the data stream; and compressing at least one of the plurality of types of data. In embodiments of this application, the data in the data stream may be classified, so that each type of classified data is subsequently compressed. This can eliminate redundancy between pieces of adjacent data and redundancy between pieces of non-adjacent data, thereby improving compression flexibility.

## Description

This application claims priority to Chinese Patent Application No. 202310475629.0, filed on April 26, 2023 and entitled "DATA COMPRESSION METHOD AND APPARATUS, COMPUTER DEVICE, AND STORAGE MEDIUM", which is incorporated herein by reference in its entirety.

### TECHNICAL FIELD

Embodiments of this application relate to the field of data storage technologies, and in particular, to a data compression method and apparatus, a computer device, and a storage medium.

### BACKGROUND

With development of internet technologies, a computer device usually needs to store a large amount of numeric data. For example, an environment monitoring system needs to store a temperature of a city at each time point every day in a computer device. To improve data storage efficiency, such data may be compressed before being stored, thereby reducing storage space.

In a related technology, for a to-be-stored data stream, current data may be compressed based on a relationship between the data and a previous piece of adjacent data, to eliminate redundancy between the pieces of adjacent data. For example, a difference between the current data and the previous piece of adjacent data may be calculated, and the current data is compressed based on a result obtained through difference calculation. In this way, the redundancy between the pieces of adjacent data in the data stream can be removed.

However, in the related technology, only the redundancy between the pieces of adjacent data can be eliminated, and compression flexibility is low.

### SUMMARY

Embodiments of this application provide a data compression method and apparatus, a computer device, and a storage medium, to classify data, and then compress each type of classified data. This can eliminate redundancy between pieces of adjacent data and redundancy between pieces of non-adjacent data, thereby improving compression flexibility. The technical solutions are as follows:

According to a first aspect, a data compression method is provided. In the method: obtaining a to-be-compressed data stream, where the data stream includes a plurality of pieces of data; determining a plurality of types of data from the plurality of pieces of data based on context information of each of the plurality of pieces of data, where each of the plurality of types of data includes at least one of the plurality of pieces of data, and the context information of each piece of data indicates data before and/or after corresponding data in the data stream; and compressing at least one of the plurality of types of data.

In this embodiment of this application, the data in the data stream can be classified, so that each type of classified data is subsequently compressed. This can eliminate redundancy between pieces of adjacent data and redundancy between pieces of non-adjacent data, thereby improving compression flexibility.

Based on the method provided in the first aspect, in a possible implementation, an implementation process of determining the plurality of types of data from the plurality of pieces of data based on the context information of each of the plurality of pieces of data may be: determining at least one piece of first data in the plurality of pieces of data, where the first data is data that appears for the non-first time in the data stream, and using each piece of first data as one type of same data; and classifying at least one piece of second data other than the at least one piece of first data in the plurality of pieces of data based on a similarity, to obtain at least one type of similar data.

Same data and similar data in the data stream can be compressed in different manners. Therefore, in this embodiment of this application, the data in the data stream can be mined from two dimensions: a same dimension and a similar dimension. In addition, a compression rate of compressing the same data is higher than a compression rate of compressing the similar data. Therefore, the data compression rate can be further improved by mining the same data and the similar data.

Based on the method provided in the first aspect, in a possible implementation, an implementation process of compressing the at least one of the plurality of types of data may be: for each piece of first data, determining a repeated appearance rule of each piece of first data as compressed data of corresponding first data, where the repeated appearance rule indicates an association between the corresponding first data and third data, and the third data is data that is in the data stream and that precedes the first data and that is the same as the first data; and for any of the at least one type of similar data, if the any type of similar data includes a plurality of pieces of second data, determining a compression algorithm corresponding to the any type of similar data, and compressing the any type of similar data according to the compression algorithm corresponding to the any type of similar data, to obtain compressed data corresponding to each piece of second data in the any type of similar data.

After the same data and the similar data in the data stream are mined, the same data and the similar data can be compressed in different manners, to improve the data compression rate.

Based on the method provided in the first aspect, in a possible implementation, an implementation process of determining the at least one piece of first data in the plurality of pieces of data may be: sequentially inputting the plurality of pieces of data to each of at least one predictor, where each predictor is configured to predict a predicted value of currently input data based on data input before current time; and for an i^{th} piece of data in the plurality of pieces of data, if a difference between a predicted value output by a first predictor in the at least one predictor and the i^{th} piece of data is 0, determining the i^{th} piece of data as one piece of first data.

In this embodiment of this application, the same data in the data stream can be mined by using the predictor.

Based on the method provided in the first aspect, in a possible implementation, an implementation process of compressing the at least one of the plurality of types of data may be: determining an identifier of the first predictor as compressed data of the i^{th} piece of data.

A prediction algorithm of the first predictor can be determined based on the identifier of the first predictor, and the i^{th} piece of data can be subsequently restored according to the prediction algorithm. Therefore, when the first data is obtained through mining by using the first predictor, the repeated appearance rule of the first data can be the identifier of the first predictor. In other words, the identifier of the first predictor is determined as the compressed data of the i^{th} piece of data.

Based on the method provided in the first aspect, in a possible implementation, in the method: if a difference between a predicted value output by each of the at least one predictor and the i^{th} piece of data is not 0, searching each of at least one hash table for data the same as the i^{th} piece of data; and if a first hash table in the at least one hash table stores the data the same as the i^{th} piece of data, determining the i^{th} piece of data as one piece of first data.

In this embodiment of this application, the same data can be mined by using both the predictor and the hash table, to fully mine the same data in the data stream.

Based on the method provided in the first aspect, in a possible implementation, an implementation process of compressing the at least one of the plurality of types of data may be: determining an identifier of the first hash table and a hash value of the i^{th} piece of data in the first hash table as compressed data of the i^{th} piece of data.

A specific hash table that is the first hash table can be determined based on the identifier of the first hash table, and the i^{th} piece of data can be subsequently restored based on the hash value of the i^{th} piece of data in the first hash table. Therefore, when the first data is obtained through mining based on the first hash table, the repeated appearance rule of the first data can be the identifier of the first hash table and the hash value corresponding to the first data in the first hash table. In other words, the identifier of the first hash table and the hash value of the i^{th} piece of data in the first hash table are determined as the compressed data of the i^{th} piece of data.

Based on the method provided in the first aspect, in a possible implementation, in the method: if the difference between the predicted value output by each of the at least one predictor and the i^{th} piece of data is not 0, updating the at least one predictor, where a difference between a predicted value output by a second predictor in at least one updated predictor and the i^{th} piece of data is 0.

When the difference between the predicted value output by each of the at least one predictor and the i^{th} piece of data is not 0, the at least one predictor can be further updated, so that when the data the same as the i^{th} piece of data subsequently appears, the data that repeatedly appears can be mined by using the at least one updated predictor.

Based on the method provided in the first aspect, in a possible implementation, in the method: if there is no data the same as the i^{th} piece of data in the at least one hash table, updating the at least one hash table, where a second hash table in at least one updated hash table stores the data the same as the i^{th} piece of data.

If no data the same as the i^{th} piece of data is stored in the at least one hash table, it indicates that neither the current predictor nor the hash table mines the data the same as the i^{th} piece of data. In this case, the at least one hash table can be further updated, so that when the data the same as the i^{th} piece of data subsequently appears, the data that repeatedly appears can be mined based on the at least one updated hash table.

Based on the method provided in the first aspect, in a possible implementation, in the method: if there is no data the same as the i^{th} piece of data in the at least one hash table, generating label information of the i^{th} piece of data, where the label information indicates that the i^{th} piece of data is one piece of second data.

If no data the same as the i^{th} piece of data is stored in the at least one hash table, it indicates that neither the current predictor nor the hash table mines the data the same as the i^{th} piece of data. In this case, the label information of the i^{th} piece of data can be further generated, and the label information indicates that the i^{th} piece of data is one piece of second data, so that remaining second data is subsequently classified based on the similarity.

Based on the method provided in the first aspect, in a possible implementation, for the any of the at least one type of similar data, a distance between any two pieces of data in the any type of similar data is less than a reference distance.

The plurality of pieces of second data can be classified based on the distance between different pieces of second data.

According to a second aspect, a data compression apparatus is provided. The data compression apparatus has a function of implementing behavior of the data compression method according to the first aspect. The data compression apparatus includes at least one module, and the at least one module is configured to implement the data compression method according to the first aspect.

According to a third aspect, a computer device is provided. A structure of the computer device includes a processor and a memory. The memory is configured to: store a program that supports the computer device in performing the data compression method according to the first aspect, and store data used to implement the data compression method according to the first aspect. The processor is configured to execute the program stored in the memory. An operation apparatus of the storage device may further include a communication bus, and the communication bus is configured to establish a connection between the processor and the memory.

According to a fourth aspect, a computer-readable storage medium is provided. The computer-readable storage medium stores instructions, and when the instructions are run on a computer, the computer is enabled to perform the data compression method according to the first aspect.

According to a fifth aspect, a computer program product including instructions is provided. When the computer program product runs on a computer, the computer is enabled to perform the data compression method according to the first aspect.

Technical effect achieved in the second aspect, the third aspect, the fourth aspect, and the fifth aspect is similar to that achieved by corresponding technical means in the first aspect. Details are not described herein again.

### BRIEF DESCRIPTION OF DRAWINGS

FIG. 1 is a flowchart of a compression algorithm for numeric data according to an embodiment of this application;
FIG. 2 is a flowchart of another compression algorithm for numeric data according to an embodiment of this application;
FIG. 3 is a diagram of an architecture of a data storage system according to an embodiment of this application;
FIG. 4 is a diagram of a scenario in which data is flushed to a disk according to an embodiment of this application;
FIG. 5 is a diagram of a scenario in which computing nodes perform communication with each other according to an embodiment of this application;
FIG. 6 is a flowchart of a data compression method according to an embodiment of this application;
FIG. 7 is a schematic flowchart of mining same data according to an embodiment of this application;
FIG. 8 is a diagram of updating data in a hash table based on an aging value according to an embodiment of this application;
FIG. 9 is a diagram of updating an aging value according to an embodiment of this application;
FIG. 10 is a diagram of representation of a floating-point value 0.152625 in a binary format according to an embodiment of this application;
FIG. 11 is a diagram of obtaining similar data according to an embodiment of this application;
FIG. 12 is a flowchart of data compression according to an embodiment of this application;
FIG. 13 is another flowchart of data compression according to an embodiment of this application;
FIG. 14 is a diagram of a structure of a data compression apparatus according to an embodiment of this application; and
FIG. 15 is a diagram of a structure of a computer device according to an embodiment of this application.

### DESCRIPTION OF EMBODIMENTS

To make objectives, technical solutions, and advantages of embodiments of this application clearer, the following further describes implementations of this application in detail with reference to accompanying drawings.

It should be understood that "a plurality of" mentioned in this specification means two or more. In descriptions of this application, "/" means "or" unless otherwise specified. For example, A/B may indicate A or B. In this specification, "and/or" describes merely an association relationship between associated objects and indicates that three relationships may exist. For example, A and/or B may indicate the following three cases: Only A exists, both A and B exist, and only B exists. In addition, to clearly describe the technical solutions in embodiments of this application, terms such as "first" and "second" are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference.

Before embodiments of this application are described in detail, an application scenario in embodiments of this application is first described.

There is a large amount of numeric data in a scenario like scientific computing or artificial intelligence, which imposes great pressure on data storage and transmission. Therefore, how to compress the numeric data is a current research hotspot.

The numeric data has a large amount of mantissa and a large amount of noise. Therefore, a compression algorithm based on context matching does not work well in such data with high entropy. In addition, a lossy compression technology can remove low-order noise of the numeric data. However, a data owner cannot accept lossy data obtained with heavy investments. The data owner usually needs to control lossy steps. Therefore, in the storage field, a lossless compression technology is widely studied.

The numeric data is characterized by continuity in a time sequence or local continuity in space due to its generation process, which specifically means that adjacent data usually fluctuates slightly. Based on the characteristic, a compression algorithm may be specifically designed to eliminate redundancy between the pieces of adjacent data.

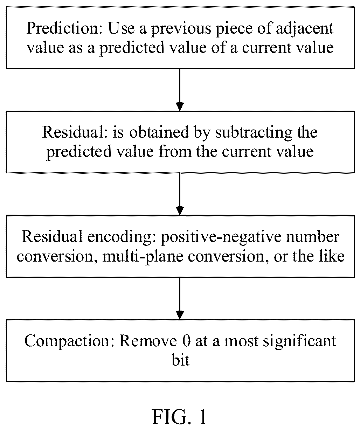

FIG. 1 is a flowchart of a compression algorithm for numeric data according to an embodiment of this application. As shown in FIG. 1, the compression algorithm includes the following steps.
1. Prediction: A previous value adjacent to a current value is used as a predicted value of the current value.
2. Difference calculation: A difference is obtained by subtracting the predicted value from the current value, and the difference is used as a residual of the current value.
3. Residual encoding: The residual of the current value is encoded to obtain a residual code of the current value. For example, an encoding manner includes positive-negative number conversion, multi-plane conversion, or the like.
4. Compaction: A most significant bit of each residual code is recorded, and 0 before the most significant bit is removed to implement compaction.

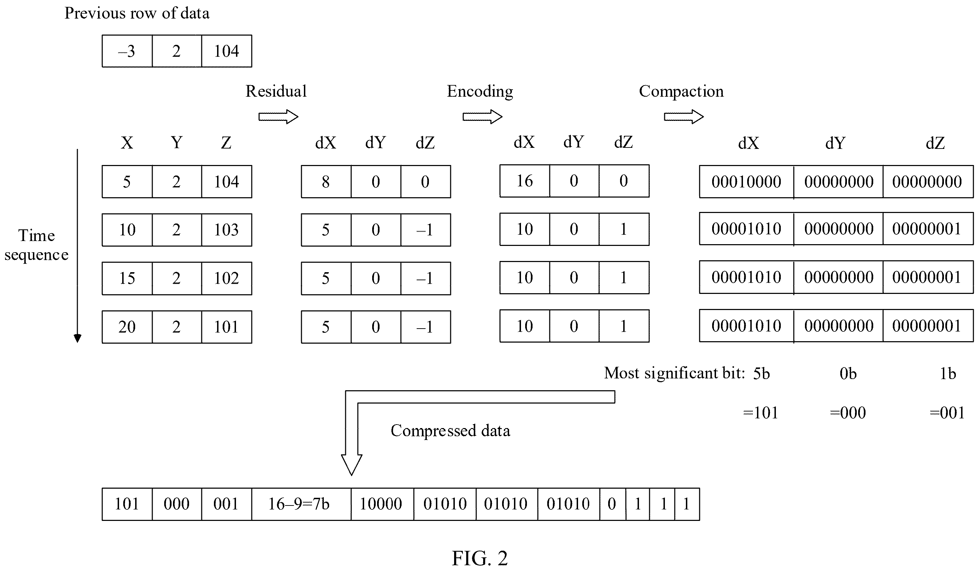

The following describe the compression algorithm shown in FIG. 1 by using FIG. 2 as an example.

As shown in FIG. 2, it is assumed that a to-be-compressed data stream sequentially includes the following four rows of data (5, 2, 104), (10, 2, 103), (15, 2, 102), and (20, 2, 101). Each row of data includes three values in an X dimension, a Y dimension, and a Z dimension. In addition, as shown in FIG. 2, a previous row of data adjacent to (5, 2, 104) is (-3, 2, 104).

As shown in FIG. 2, prediction and difference calculation are first performed on each value in each row of data, to obtain a residual corresponding to each value. For example, for the value 5 in the first row of data, a difference between the value 5 and the value -3 in the previous row of data is calculated, to obtain a residual 8 of the value 5. By analogy, a residual of each value in the four rows of data is obtained.

Then, the residual of each value is encoded, and an encoding manner is: multiplying a positive number by 2, and multiplying a negative number by 2+1 and then obtaining an absolute value thereof. For example, for the residual 8 of the value 5, a value 16 obtained by multiplying 8 by 2 is used as a residual code of the value 5.

After a residual code of each value is obtained, the residual code of each value is represented in a binary manner, and compaction is separately performed in the three dimensions of X, Y, and Z. Compaction in the X dimension is used as an example for description. As shown in FIG. 2, residual codes of four values in the X dimension are respectively represented as 00010000, 00001010, 00001010, and 00001010, and a most significant bit of the four binary residual codes is 5. Therefore, the most significant bit 5 is recorded (recorded as 101 in the binary manner), and the first three bits of the four binary residual codes are removed, to obtain compressed data: 101 (used to record the most significant bit), and 10000/01010/01010/01010. For other dimensions, refer to this process.

In the compression algorithm, redundancy between pieces of adjacent data is eliminated through prediction and difference calculation, and redundancy between periodic or cross-distance similar values cannot be processed. Therefore, compression flexibility is excessively low.

In view of this, embodiments of this application provide a data compression method, to classify data, and then compress each type of classified data. This can eliminate redundancy between pieces of adjacent data and redundancy between pieces of non-adjacent data, thereby improving compression flexibility.

The following describes in detail a data storage system, a data compression method, and a related apparatus that are provided in embodiments of this application.

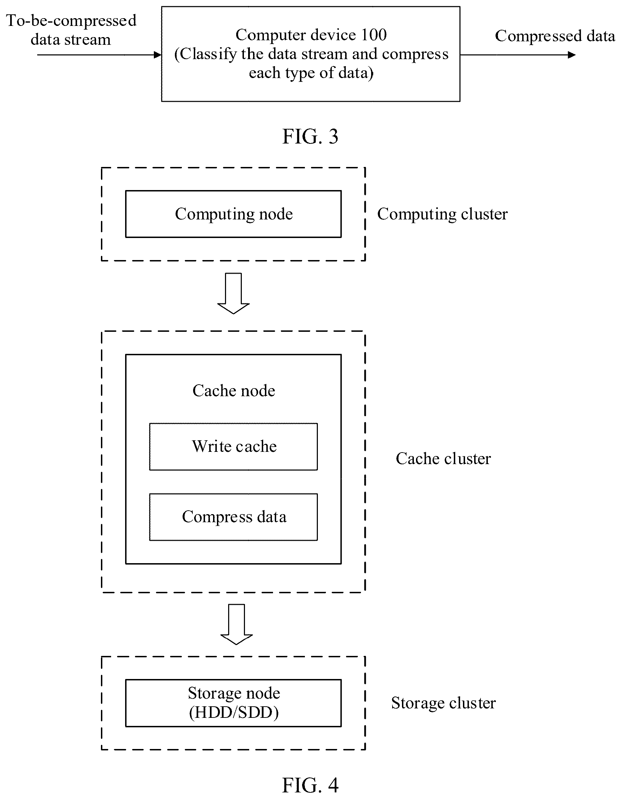

FIG. 3 is a diagram of an architecture of a data storage system according to an embodiment of this application. As shown in FIG. 3, the data storage system includes a computer device 100. The computer device 100 is configured to: receive a to-be-compressed data stream, compress each piece of data in the data stream based on the data compression method provided in embodiments of this application, to obtain compressed data of each piece of data in the data stream, and store the compressed data of each piece of data. Specifically, the data stream is classified, and each type of data is compressed.

The data compression method provided in embodiments of this application may be applied to a scenario in which data is flushed to a disk, or may be applied to a scenario in which computing nodes perform communication with each other, or optionally, may be applied to another scenario in which batch data needs to be stored. The following uses the two scenarios as examples for description.

FIG. 4 is a diagram of a scenario in which data is flushed to a disk according to an embodiment of this application. As shown in FIG. 4, a data storage system includes a computing cluster, a cache cluster, and a storage cluster. The computing cluster includes a plurality of computing nodes, the cache cluster includes a plurality of cache nodes, and the storage cluster includes a plurality of storage nodes. Each computing node may communicate with one or more cache nodes, and each cache node may communicate with one or more storage nodes.

After obtaining data, an application (application, APP) of any computing node in the computing cluster sends the data to the one or more cache nodes in the cache cluster. The cache cluster is configured to cache the received data, that is, store the received data in a write cache. In addition, the cache cluster is configured to: compress the data in the write cache in the data compression manner provided in embodiments of this application, and write compressed data into the one or more storage nodes in the storage cluster, to complete an operation flushing the data to the disk.

For example, the storage node may be a storage device like a conventional hard disk drive (hard disk drive, HDD) or a solid-state drive (solid-state drive, SDD).

In the scenario shown in FIG. 4, the computer device shown in FIG. 3 may be the cache node in the cache cluster.

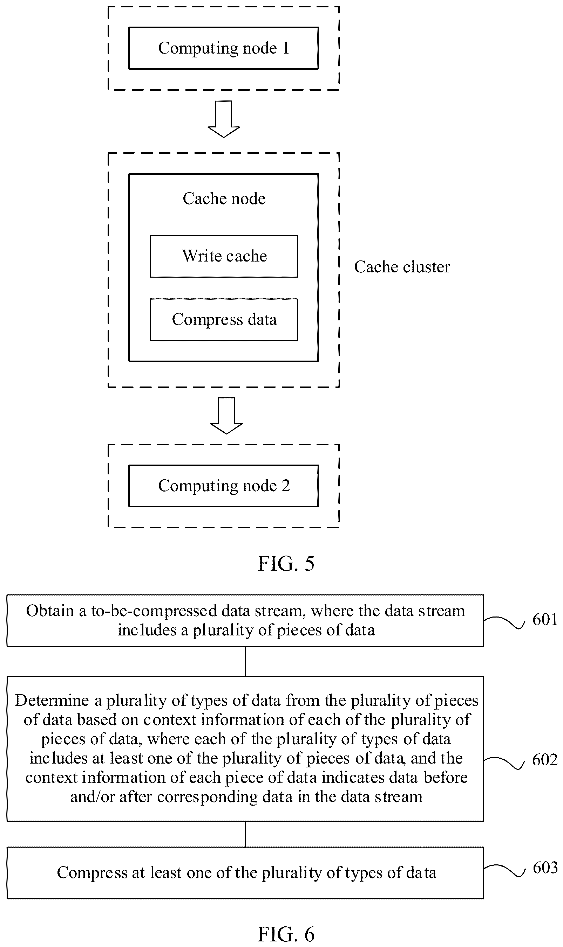

FIG. 5 is a diagram of a scenario in which computing nodes perform communication with each other according to an embodiment of this application. As shown in FIG. 5, a data storage system includes a computing cluster and a cache cluster. The computing cluster includes a plurality of computing nodes, for example, a computing node 1 and a computing node 2 in FIG. 5, and the cache cluster includes a plurality of cache nodes. Each computing node may communicate with one or more cache nodes.

As shown in FIG. 5, after obtaining data, the computing node 1 caches the data to a write cache of a cache node in the cache cluster. The cache node compresses the data in the write cache by using the method provided in embodiments of this application. The computing node 2 may decompress compressed data stored in the write cache of the cache node, to obtain the data of the computing node 1, so as to complete communication between the computing node 1 and the computing node 2.

In the scenario shown in FIG. 5, the computer device shown in FIG. 3 may be the cache node in the cache cluster.

FIG. 6 is a flowchart of a data compression method according to an embodiment of this application. As shown in FIG. 6, the method includes the following several steps.

Step 601: Obtain a to-be-compressed data stream, where the data stream includes a plurality of pieces of data.

The to-be-compressed data stream may be understood as a plurality of pieces of data sorted in order. A manner in which the data in the data stream is sorted is not limited in embodiments of this application.

In addition, the data in the data stream may be numeric data, or may be another type of data, for example, may be character data. In other words, the compression method provided in this embodiment of this application may be applied to any type of data.

In addition, a length of the data in the data stream is a reference length, to facilitate subsequent compression. In other words, the method provided in this embodiment of this application may be applied to a scenario in which the length of the data in the data stream is fixed.

Step 602: Determine a plurality of types of data from the plurality of pieces of data based on context information of each of the plurality of pieces of data, where each of the plurality of types of data includes at least one of the plurality of pieces of data, and the context information of each piece of data indicates data before and/or after corresponding data in the data stream.

In this embodiment of this application, the data in the data stream can be classified, so that each type of classified data is subsequently compressed based on step 603. This can eliminate redundancy between pieces of adjacent data and redundancy between pieces of non-adjacent data, thereby improving compression flexibility.

Same data and similar data in the data stream can be compressed in different manners. Therefore, in this embodiment of this application, the data in the data stream can be mined from two dimensions: a same dimension and a similar dimension.

In addition, a compression rate of compressing the same data is higher than a compression rate of compressing the similar data. Therefore, the data compression rate can be further improved by mining the same data and the similar data.

Based on this, in some embodiments, step 602 may be implemented by using the following two steps.

Step 1: Mine the same data.

In this scenario, an implementation of determining the plurality of types of data from the plurality of pieces of data based on the context information of each of the plurality of pieces of data may be: determining at least one piece of first data in the plurality of pieces of data, where the first data is data that appears for the non-first time in the data stream, and using each piece of first data as one type of same data.

Step 2: Mine the similar data.

In this scenario, an implementation of determining the plurality of types of data from the plurality of pieces of data based on the context information of each of the plurality of pieces of data may be: classifying at least one piece of second data other than the at least one piece of first data in the plurality of pieces of data based on a similarity, to obtain at least one type of similar data.

In other words, in this embodiment of this application, the data stream is first searched for data that repeatedly appears, to mine the same data in the data stream. Then, remaining data in the data stream is classified based on the similarity, to mine the similar data in the data stream.

The following first describes an implementation of step 1 in detail.

An implementation of determining the at least one piece of first data in the plurality of pieces of data may be: sequentially inputting the plurality of pieces of data to each of at least one predictor, where each predictor is configured to predict a predicted value of currently input data based on data input before current time; and for an i^{th} piece of data in the plurality of pieces of data, if a difference between a predicted value output by a first predictor in the at least one predictor and the i^{th} piece of data is 0, determining the i^{th} piece of data as one piece of first data.

In other words, in this embodiment of this application, the same data in the data stream can be mined by using the predictor.

The predictor is configured to predict the predicted value of the currently input data based on the data input before the current time. For example, the predictor corresponds to a prediction algorithm. For any piece of data input at current time (briefly referred to as current data), the predictor may determine, as a predicted value of the current data according to the prediction algorithm, one piece of data from data input before the current time.

For example, the prediction algorithm may be using, as the predicted value of the current data, a last piece of data in the data input before the current time. Alternatively, the prediction algorithm may be using, as the predicted value of the current data, a last but nine piece of data in the data input before the current time.

In this way, for the current data input to the predictor at the current time, if the difference between the predicted value output by the predictor and the current data is 0, it indicates that the current data is the same as a piece of previously input data, that is, the current data is the data that appears for the non-first time.

In addition, different predictors in the at least one predictor correspond to different prediction algorithms, to mine the same data from a plurality of dimensions instead of mining only adjacent same data.

In addition, after the i^{th} piece of data is input to each of the at least one predictor, if a difference between a predicted value output by each of the at least one predictor and the i^{th} piece of data is not 0, it indicates that data the same as the i^{th} piece of data fails to be mined by using the predictor. In this case, to avoid a possible error of the predictor, each of at least one hash table may be further searched for the data the same as the i^{th} piece of data; and if a first hash table in the at least one hash table stores the data the same as the i^{th} piece of data, the i^{th} piece of data is determined as one piece of first data.

In other words, in this embodiment of this application, the same data can be mined by using both the predictor and the hash table, to fully mine the same data in the data stream. Optionally, in this embodiment of this application, the same data can be mined by using only the predictor or the hash table. In the following embodiments, an example in which the same data is mined by using both the predictor and the hash table is used for description.

For any of the at least one hash table, the hash table corresponds to a hash algorithm, and a hash value obtained through calculation according to the hash algorithm corresponding to the hash table indicates a storage location in the hash table, for example, may indicate a specific row in the hash table. The storage location is used to store data corresponding to the hash value.

Based on this, an implementation of searching each of the at least one hash table for the data the same as the i^{th} piece of data may be: for any of the at least one hash table, calculating a hash value of the i^{th} piece of data according to a hash algorithm corresponding to the hash table, then searching the hash table for data corresponding to the hash value, and if found data is the same as the i^{th} piece of data, determining that the data the same as the i^{th} piece of data is stored in the hash table. In other words, it indicates that the i^{th} piece of data is the same as the data input before the current time, so that the same data is mined.

In addition, different hash tables in the at least one hash table correspond to different hash algorithms, so that the same data is mined in all dimensions, to avoid a case in which the same data is not fully mined.

In addition, when the difference between the predicted value output by each of the at least one predictor and the i^{th} piece of data is not 0, the at least one predictor can be further updated, so that when the data the same as the i^{th} piece of data subsequently appears, the data that repeatedly appears can be mined by using at least one updated predictor.

In other words, when the difference between the predicted value output by each of the at least one predictor and the i^{th} piece of data is not 0, the at least one predictor is updated, where a difference between a predicted value output by a second predictor in the at least one updated predictor and the i^{th} piece of data is 0.

For example, an implementation of updating the at least one predictor may be: updating a prediction algorithm of a predictor in the at least one predictor, so that if a j^{th} piece of data is subsequently received, and the j^{th} piece of data and the i^{th} piece of data are same data, it may be determined, by using the predictor, that the j^{th} piece of data is data that repeatedly appears.

In addition, if no data the same as the i^{th} piece of data is stored in the at least one hash table, it indicates that neither the current predictor nor the hash table mines the data the same as the i^{th} piece of data. In this case, the at least one hash table can be further updated, so that when the data the same as the i^{th} piece of data subsequently appears, the data that repeatedly appears can be mined based on at least one updated hash table.

In other words, when no data the same as the i^{th} piece of data is stored in the at least one hash table, the at least one hash table is updated, where a second hash table in the at least one updated hash table stores the data the same as the i^{th} piece of data.

For example, an implementation of updating the at least one hash table may be: for any of the at least one hash table, if no data is stored in a storage location indicated by a hash value corresponding to the i^{th} piece of data in the hash table, storing the i^{th} piece of data in the storage location indicated by the hash value in the hash table. In this way, if a j^{th} piece of data is subsequently received, and the j^{th} piece of data and the i^{th} piece of data are same data, it may be determined, based on the hash table, that the j^{th} piece of data is data that repeatedly appears.

In addition, if no data the same as the i^{th} piece of data is stored in the at least one hash table, it indicates that neither the current predictor nor the hash table mines the data the same as the i^{th} piece of data. In this case, label information of the i^{th} piece of data can be further generated, and the label information indicates that the i^{th} piece of data is one piece of second data, so that remaining second data is subsequently classified based on the similarity.

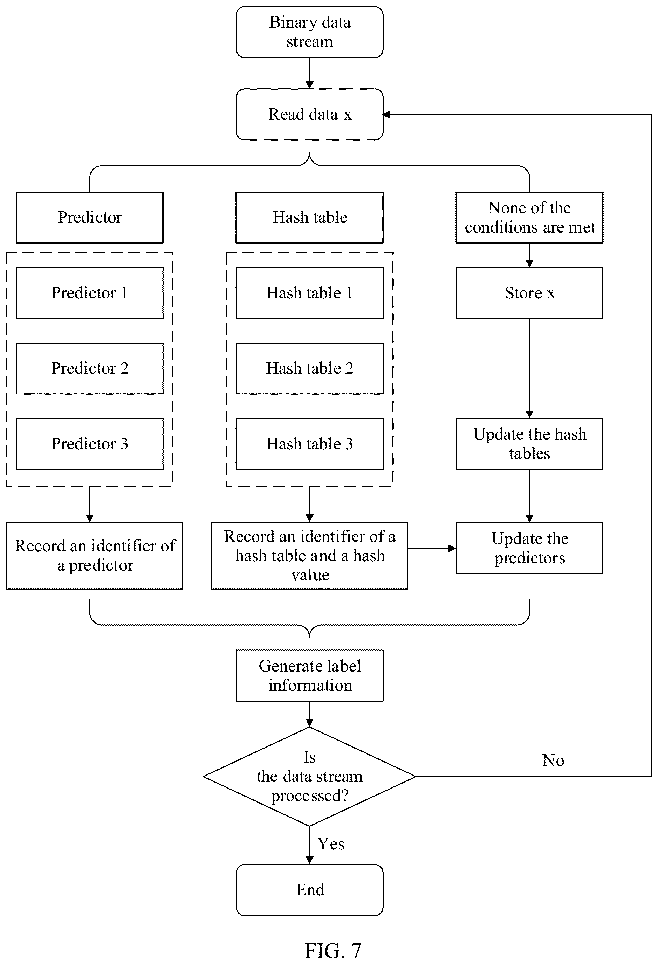

FIG. 7 is a schematic flowchart of mining same data according to an embodiment of this application.

As shown in FIG. 7, it is assumed that data in a data stream is binary data. For currently to-be-processed data x, whether the data x is the same as previously input data is first determined by using a plurality of predictors. As shown in FIG. 7, whether the data x is the same as the previously input data may be separately determined by using a predictor 1, a predictor 2, and a predictor 3.

If it is determined, by using a predictor in the predictor 1, the predictor 2, and the predictor 3, that the data x is the same as a piece of previously input data, an identifier of the predictor may be recorded for subsequent storage and use.

If the data the same as the data x is not determined by using the three predictors, whether the data x is the same as the previously input data may be further determined based on a plurality of hash tables. As shown in FIG. 7, whether the data x is the same as the previously input data may be separately determined based on a hash table 1, a hash table 2, and a hash table 3.

If it is determined, based on a hash table in the hash table 1, the hash table 2, and the hash table 3, that the data x is the same as a piece of previously input data, an identifier of the hash table and a hash value corresponding to the data x in the hash table may be recorded for subsequent storage and use. In addition, in this case, the plurality of predictors may be further updated.

If the data the same as the data x is not determined based on the three hash tables, the plurality of predictors and the plurality of hash tables are updated, and label information of the data x is generated, to indicate that the data x is data that appears for the first time in the data stream, so that data that appears for the first time is subsequently classified based on a similarity.

The procedure shown in FIG. 7 is performed on each piece of data in the data stream, so that same data mining can be performed on all the data in the data stream.

In addition, for any one of the hash tables, a corresponding aging value may be further stored at a storage location indicated by each hash value in the hash table. The aging value indicates validity of data corresponding to a corresponding hash value. For example, a smaller aging value corresponding to the hash value indicates that data corresponding to the hash value does not appear for a long time.

In this case, for the i^{th} piece of data, if a hash table stores data corresponding to the hash value of the i^{th} piece of data, and the data that corresponds to the hash value and that is stored in the hash table is different from the i^{th} piece of data, whether to update the data corresponding to the hash value in the hash table may be further determined based on an aging value corresponding to the hash value.

For example, if the aging value is less than an aging value threshold, it indicates that validity of the data corresponding to the hash value is excessively low. In this case, the i^{th} piece of data may be updated to a storage location indicated by the hash value in the hash table, that is, the data corresponding to the hash value in the hash table is updated to the i^{th} piece of data. Correspondingly, if the aging value is not less than the aging value threshold, it indicates that validity of the data corresponding to the hash value is still high, and the data corresponding to the hash value in the hash table does not need to be updated.

A purpose of setting the aging value is as follows: Different data may correspond to a same hash value in a hash algorithm. Therefore, if in a hash algorithm of a hash table, data corresponding to the hash value corresponding to the i^{th} piece of data is stored in the hash table, the i^{th} piece of data may be different from the data corresponding to the hash value in the hash table. Therefore, whether the data corresponding to the hash value needs to be updated may be determined by setting the aging value.

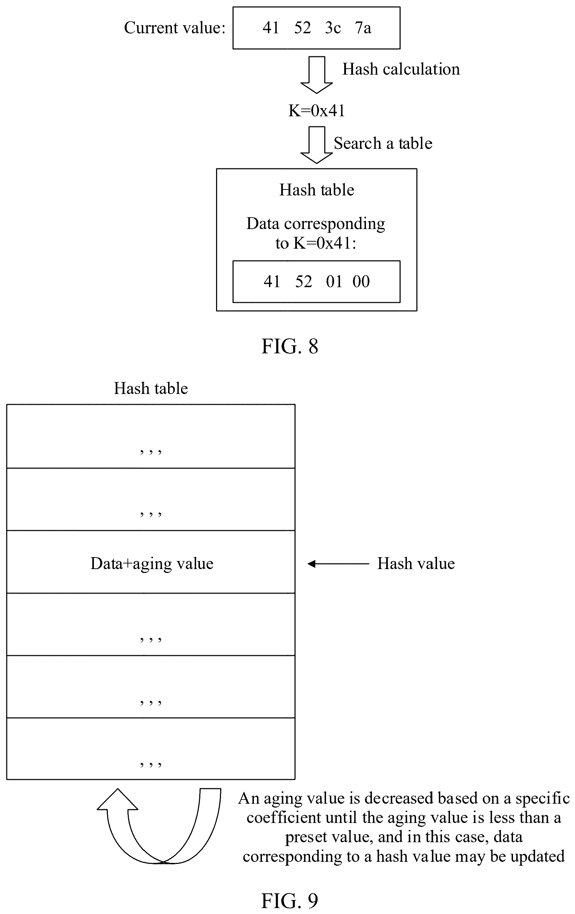

FIG. 8 is a diagram of updating data in a hash table based on an aging value according to an embodiment of this application. As shown in FIG. 8, it is assumed that the i^{th} piece of data is a current value shown in FIG. 8, and a hash value k=0x41 of the current value is obtained through calculation according to a hash algorithm corresponding to a hash table, where 0x indicates that subsequent values are hexadecimal values. It can be learned by searching the hash table that data stored at a storage location indicated by the hash value k=0x41 in the hash table is 0x41520100, which is different from the i^{th} piece of data 0x41523c7a. This case may be referred to as a hash collision. In this case, whether the data corresponding to the hash value k=0x41 in the hash table needs to be updated may be determined based on an aging value corresponding to the hash value k=0x41 in the hash table.

In addition, the aging value of the hash value in the hash table may be updated in two manners. One manner is to update the aging value at a fixed time interval. For example, the aging value is decreased at a time interval. The other manner is to perform update based on a fixed hit count. For example, each time the data corresponding to the hash value is the same as the currently to-be-processed i^{th} piece of data, the aging value is increased once. Rules for adjusting the aging value in the two scenarios may be different, and in a same scenario, adjustment amplitudes of the aging value each time may also be different.

FIG. 9 is a diagram of updating an aging value according to an embodiment of this application. As shown in FIG. 9, a hash table stores data corresponding to each hash value and an aging value corresponding to the hash value, and each hash value indicates a storage location in the hash table. As shown in FIG. 9, for an aging value corresponding to any hash value, the aging value corresponding to the hash value may be decreased at a fixed time interval based on a specific coefficient until the aging value is less than a preset value. In this case, if the hash value of the i^{th} piece of data is the same as the hash value, data corresponding to the hash value may be updated to the i^{th} piece of data.

After the same data in the data stream is mined in step 1, similar data mining may continue to be performed on the remaining data (namely, the second data) in step 2. The following describes an implementation of step 2 in detail.

In some embodiments, a plurality of pieces of second data can be classified based on a distance between different pieces of second data. In this way, for any of the at least one type of classified similar data, a distance between any two pieces of data in the any type of similar data is less than a reference distance.

The distance between the any two pieces of data may be a Euclidean distance, a Hamming distance, a Manhattan distance, a Chebyshev distance, or the like.

For example, the plurality of pieces of second data may be classified in a weak hash manner.

For example, corresponding to the plurality of pieces of second data, second data with a same low-order bit may be used as one type of similar data, second data with a same high-order bit may be used as one type of similar data, or second data with a same middle bit may be used as one type of similar data.

For the numeric data, low-order bits of the data are usually disordered, and high-order bits have a specific rule. In addition, usually, bits representing a sign and an exponent do not change greatly. Therefore, for the numeric data, second data with a same low-order bit may be defined as one type of similar data. In this way, residual entropy can be reduced in subsequent prediction.

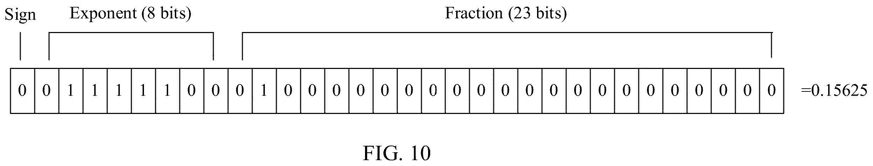

FIG. 10 is a diagram of representation of a floating-point value 0.152625 in a binary format according to an embodiment of this application. As shown in FIG. 10, from high-order bits to low-order bits, a first bit represents a sign (sign), a second bit to a ninth bit represent an exponent (exponent), and a tenth bit to a 32^{nd} bit represent a fraction (fraction). It can be learned from FIG. 10 that the sign part and the exponent part occupy the high-order bits, occupy a small quantity of bits, and therefore, has a small change range. However, the fraction part occupies the low-order bits, occupies a large quantity of bits, and therefore, has a large change range. Based on this, it may be considered that the data is classified based on whether low-order bits are the same.

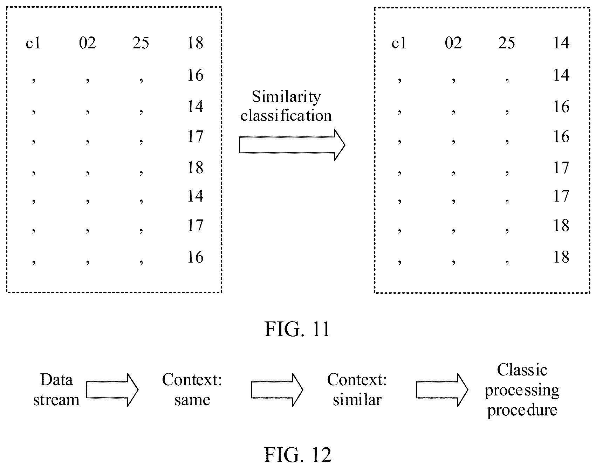

FIG. 11 is a diagram of obtaining similar data according to an embodiment of this application. Each piece of data shown in FIG. 11 is hexadecimal notation of a value in a floating (float)-point format. In addition, only low-order parts of some data in FIG. 11 are shown, and high-order parts of the data are not shown in FIG. 11.

As shown in FIG. 11, data with same low-order bits (a last bit and a last but one bit) is used as one type of similar data, to obtain four types of data. One type includes two pieces of data whose low-order bits are 14, one type includes two pieces of data whose low-order bits are 16, one type includes two pieces of data whose low-order bits are 17, and one type includes two pieces of data whose low-order bits are 18.

In addition, in this embodiment of this application, there may be a plurality of weak hash manners. Examples are not described one by one in this embodiment of this application.

Optionally, the plurality of pieces of second data may alternatively be classified in a clustering manner. The clustering manner may be K-means (K-means) clustering, another clustering manner, or the like.

The foregoing descriptions are provided by using an example in which in the data stream, the same data is first mined, and then the similar data is mined. Optionally, in this embodiment of this application, the data stream may be directly classified. In this scenario, the same data may also be classified into one type. However, efficiency in this manner is lower than efficiency of mining the same data by using the predictor and the hash table.

Step 603: Compress at least one of the plurality of types of data.

The following describes step 603 by using an example in which in the data stream, the same data is first mined, and then the similar data is mined in step 602.

In step 1 of step 602, after each piece of first data is obtained, for each piece of first data, a repeated appearance rule of each piece of first data is determined as compressed data of corresponding first data, where the repeated appearance rule indicates an association between the corresponding first data and third data, and the third data is data that is in the data stream and that precedes the first data and that is the same as the first data.

For example, when the first data is obtained through mining by using a predictor, the repeated appearance rule of the first data can be an identifier of the predictor. In other words, in step 1 of step 602, an identifier of the first predictor is determined as compressed data of the i^{th} piece of data.

A prediction algorithm of the first predictor can be determined based on the identifier of the first predictor, and the i^{th} piece of data can be subsequently restored according to the prediction algorithm.

For another example, when the first data is obtained through mining based on a hash table, the repeated appearance rule of the first data can be an identifier of the hash table and a hash value corresponding to the first data in the hash table. In other words, in step 1 of step 602, an identifier of the first hash table and a hash value of the i^{th} piece of data in the first hash table are determined as the compressed data of the i^{th} piece of data.

A specific hash table that is the first hash table can be determined based on the identifier of the first hash table, and the i^{th} piece of data can be subsequently restored based on the hash value of the i^{th} piece of data in the first hash table.

In step 2 of step 602, after the at least one type of similar data is obtained, for any of the at least one type of similar data, if the type of similar data includes a plurality of pieces of second data, a compression algorithm corresponding to the type of similar data is determined, and the type of similar data is compressed according to the compression algorithm corresponding to the type of similar data, to obtain compressed data corresponding to each piece of second data in the type of similar data.

In addition, after the compressed data corresponding to each piece of second data in the type of similar data is obtained, an identifier of a similar data type to which the second data belongs further needs to be stored when the compressed data is stored, so that the corresponding compression algorithm is first obtained based on the identifier of the similar data type during subsequent decompression, and further, the second data is restored according to the compression algorithm and the compressed data.

Correspondingly, if the type of similar data includes one piece of second data, the second data is directly stored.

The compression algorithm corresponding to the type of similar data may be, for example, any conventional compression algorithm. For example, the compression algorithm may be the compression algorithm shown in FIG. 1. In addition, compression algorithms corresponding to different types of similar data may be different or may be the same.

For example, for a type of similar data including a plurality of pieces of second data, a type of the type of similar data may be determined based on a fluctuation degree, entropy information, or the like. The type may be, for example, an integer type or a decimal type. Then, a compression algorithm that matches the type of the type of similar data is selected from a plurality of compression algorithms. A specific implementation is not described in detail herein.

In conclusion, in this embodiment of this application, the data in the data stream can be classified, so that each type of classified data is subsequently compressed based on step 603. This can eliminate the redundancy between the pieces of adjacent data and the redundancy between the pieces of the non-adjacent data, thereby improving the compression flexibility.

Further, the data stream may be first searched for the data that repeatedly appears, to mine the same data in the data stream. Then, the remaining data in the data stream is classified based on the similarity, to mine the similar data in the data stream. In this way, classification of the data in the data stream is completed.

FIG. 12 is a flowchart of data compression according to an embodiment of this application. As shown in FIG. 12, for a data stream including numeric data, same data may be mined based on context information, and then similar data may be mined based on the context information. Any type of similar data obtained through mining may be compressed based on a classic compression processing procedure.

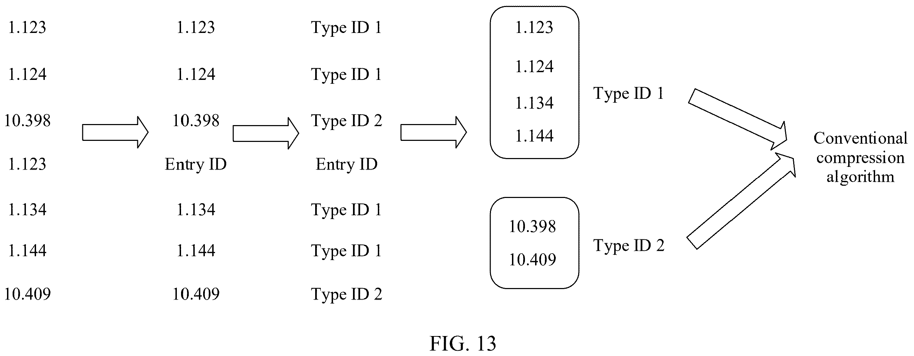

The following describes the procedure shown in FIG. 12 by using FIG. 13 as an example.

As shown in FIG. 13, it is assumed that the data included in the data stream is 1.123, 1.124, 10.398, 1.123, 1.134, 1.144, and 10.409. Through same data mining, it is found that the fourth piece of data 1.123 is repeated data. Therefore, an identifier of a predictor or an identifier and a hash value of a hash table that obtain, through mining, the fourth piece of data as the same data are directly stored. For ease of description, the identifier of the predictor or the identifier and the hash value of the hash table that obtain, through mining, the fourth piece of data as the same data are referred to as an entry identifier (identifier, ID).

Then, similarity mining is performed on the remaining six pieces of data. As shown in FIG. 13, two types of similar data are obtained. One type includes 1.123 in the first row, 1.24 in the second row, 1.134 in the fifth row, and 1.144 in the sixth row. An identifier of the type is referred to as a type ID 1. The other type includes 10.398 in the third row and 10.409 in the second row, and an identifier of the type is referred to as a type ID 2. For each type of data, a type ID of the type of data is recorded, and the data is compressed according to a conventional compression algorithm. The conventional compression algorithm may include, for example, operations such as prediction, residual obtaining, conversion, and encoding.

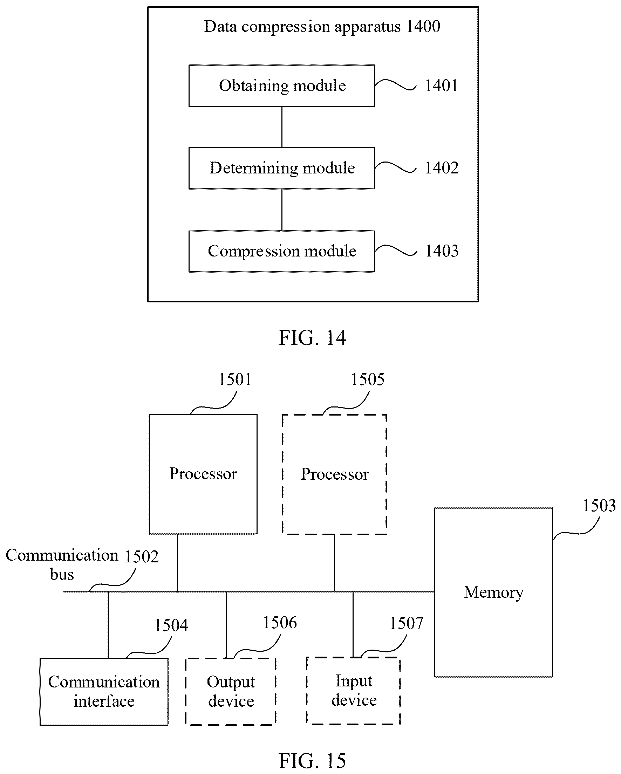

FIG. 14 is a diagram of a structure of a data compression apparatus according to an embodiment of this application. As shown in FIG. 14, the apparatus includes the following several modules:
an obtaining module 1401, configured to obtain a to-be-compressed data stream, where the data stream includes a plurality of pieces of data, and for a specific implementation, refer to step 601 in the embodiment in FIG. 6;
a determining module 1402, configured to determine a plurality of types of data from the plurality of pieces of data based on context information of each of the plurality of pieces of data, where each of the plurality of types of data includes at least one of the plurality of pieces of data, and the context information of each piece of data indicates data before and/or after corresponding data in the data stream, and for a specific implementation, refer to step 602 in the embodiment in FIG. 6; and
a compression module 1403, configured to compress at least one of the plurality of types of data, and for a specific implementation, refer to step 603 in the embodiment in FIG. 6.

Optionally, the determining module 1402 includes:
a determining submodule, configured to: determine at least one piece of first data in the plurality of pieces of data, where the first data is data that appears for the non-first time in the data stream, and use each piece of first data as one type of same data; and
a classification submodule, configured to classify at least one piece of second data other than the at least one piece of first data in the plurality of pieces of data based on a similarity, to obtain at least one type of similar data.

Optionally, the compression module 1403 is configured to:
for each piece of first data, determine a repeated appearance rule of each piece of first data as compressed data of corresponding first data, where the repeated appearance rule indicates an association between the corresponding first data and third data, and the third data is data that is in the data stream and that precedes the first data and that is the same as the first data; and
for any of the at least one type of similar data, if the any type of similar data includes a plurality of pieces of second data, determine a compression algorithm corresponding to the any type of similar data, and compress the any type of similar data according to the compression algorithm corresponding to the any type of similar data, to obtain compressed data corresponding to each piece of second data in the any type of similar data.

Optionally, the determining submodule is configured to:
sequentially input the plurality of pieces of data to each of at least one predictor, where each predictor is configured to predict a predicted value of currently input data based on data input before current time; and
for an i^{th} piece of data in the plurality of pieces of data, if a difference between a predicted value output by a first predictor in the at least one predictor and the i^{th} piece of data is 0, determine the i^{th} piece of data as one piece of first data.

Optionally, the compression module is configured to:
determine an identifier of the first predictor as compressed data of the i^{th} piece of data.

Optionally, the determining submodule is further configured to:
if a difference between a predicted value output by each of the at least one predictor and the i^{th} piece of data is not 0, search each of at least one hash table for data the same as the i^{th} piece of data; and
if a first hash table in the at least one hash table stores the data the same as the i^{th} piece of data, determine the i^{th} piece of data as one piece of first data.

Optionally, the compression module is configured to:
determine an identifier of the first hash table and a hash value of the i^{th} piece of data in the first hash table as compressed data of the i^{th} piece of data.

Optionally, the apparatus further includes:
a first update module, configured to: if the difference between the predicted value output by each of the at least one predictor and the i^{th} piece of data is not 0, update the at least one predictor, where a difference between a predicted value output by a second predictor in at least one updated predictor and the i^{th} piece of data is 0.

Optionally, the apparatus further includes:
a second update module, configured to: if there is no data the same as the i^{th} piece of data in the at least one hash table, update the at least one hash table, where a second hash table in at least one updated hash table stores the data the same as the i^{th} piece of data.

Optionally, the apparatus further includes:
a generation module, configured to: if there is no data the same as the i^{th} piece of data in the at least one hash table, generate label information of the i^{th} piece of data, where the label information indicates that the i^{th} piece of data is one piece of second data.

Optionally, for the any of the at least one type of similar data, a distance between any two pieces of data in the any type of similar data is less than a reference distance.

In this embodiment of this application, the data in the data stream can be classified, so that each type of classified data is subsequently compressed. This can eliminate redundancy between pieces of adjacent data and redundancy between pieces of non-adjacent data, thereby improving compression flexibility.

It should be noted that when the data compression apparatus provided in the foregoing embodiments compresses data, division into the foregoing functional modules is merely used as an example for description. In actual application, the foregoing functions can be allocated to different functional modules and implemented based on a requirement, that is, an inner structure of the device is divided into different functional modules to implement all or some of the functions described above. In addition, the data compression apparatus provided in the foregoing embodiments belongs to a same concept as the data compression method embodiment. For a specific implementation process of the data compression apparatus, refer to the method embodiment. Details are not described herein again.

FIG. 15 is a diagram of a structure of a computer device according to an embodiment of this application. Any device for compressing data in the foregoing embodiments may be implemented by using the computer device shown in FIG. 15. Refer to FIG. 15. The computer device includes a processor 1501, a communication bus 1502, a memory 1503, and at least one communication interface 1504.

The processor 1501 may be a general-purpose central processing unit (central processing unit, CPU), an application-specific integrated circuit (application-specific integrated circuit, ASIC), or one or more integrated circuits configured to control program execution in the solutions of this application.

The communication bus 1502 is configured to transmit information between the components.

The memory 1503 may be a read-only memory (read-only memory, ROM) or another type of static storage device that can store static information and instructions, or a random access memory (random access memory, RAM) or another type of dynamic storage device that can store information and instructions. The memory 1503 may alternatively be an electrically erasable programmable read-only memory (electrically erasable programmable read-only memory, EEPROM), a compact disc read-only memory (compact disc read-only memory, CD-ROM) or another compact disc storage, an optical disc storage (including a compact disc, a laser disc, an optical disc, a digital versatile disc, a Blu-ray disc, or the like), a magnetic disk or another magnetic storage device, or any other medium that can be used to carry or store expected program code in a form of an instruction or a data structure and that can be accessed by a computer. However, the memory 1503 is not limited thereto. The memory 1503 may exist independently, and is connected to the processor 1501 through the communication bus 1502. Alternatively, the memory 1503 may be integrated with the processor 1501.

The memory 1503 is configured to store program code for executing the solutions of this application, and the processor 1501 controls execution. The processor 1501 is configured to execute the program code stored in the memory 1503. The program code may include one or more software modules. The data compression apparatus in the foregoing embodiments may determine, by using the processor 1501 and one or more software modules in the program code in the memory 1503, data used to develop an application.

The communication interface 1504 uses any apparatus like a transceiver, and is configured to communicate with another device or a communication network like the Ethernet, a radio access network (radio access network, RAN), or a wireless local area network (wireless local area network, WLAN).

In specific implementation, in an embodiment, the computer device may include a plurality of processors, for example, the processor 1501 and a processor 1505 shown in FIG. 15. Each of the processors may be a single-core (single-CPU) processor, or may be a multi-core (multi-CPU) processor. The processor herein may be one or more devices, circuits, and/or processing cores configured to process data (for example, computer program instructions).

In a specific implementation, in an embodiment, the computer device may further include an output device 1506 and an input device 1507. The output device 1506 communicates with the processor 1501, and may display information in a plurality of manners. For example, the output device 1506 may be a liquid crystal display (liquid crystal display, LCD), a light-emitting diode (light-emitting diode, LED) display device, a cathode ray tube (cathode ray tube, CRT) display device, a projector (projector), or the like. The input device 1507 communicates with the processor 1501, and may receive an input of a user in a plurality of manners. For example, the input device 1507 may be a mouse, a keyboard, a touchscreen device, a sensor device, or the like.

The computer device may be a general-purpose computer device or a dedicated computer device. In a specific implementation, the computer device may be a desktop computer, a portable computer, a network server, a personal digital assistant (personal digital assistant, PDA), a mobile phone, a tablet, a wireless terminal device, a communication device, or an embedded device. A type of the computer device is not limited in embodiments of this application.

All or some of the foregoing embodiments may be implemented by software, hardware, firmware, or any combination thereof. When software is used to implement embodiments, all or some of the embodiments may be implemented in a form of a computer program product. The computer program product includes one or more computer instructions. When the computer instructions are loaded and executed on the computer, the procedures or functions according to embodiments of this application are all or partially generated. The computer may be a general-purpose computer, a dedicated computer, a computer network, or another programmable apparatus. The computer instructions may be stored in a computer-readable storage medium, or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by a computer, or a data storage device, for example, a server or a data center, integrating one or more usable media. The usable medium may be a magnetic medium (for example, a floppy disk, a hard disk drive, or a magnetic tape), an optical medium (for example, a digital versatile disc (digital versatile disc, DVD)), a semiconductor medium (for example, a solid-state drive (solid-state drive, SSD)), or the like.

A person of ordinary skill in the art may understand that all or some of the steps of embodiments may be implemented by hardware or a program instructing related hardware. The program may be stored in a computer-readable storage medium. The storage medium may be a read-only memory, a magnetic disk, an optical disc, or the like.

The foregoing descriptions are embodiments provided in this application, but are not intended to limit embodiments of this application. Any modification, equivalent replacement, or improvement made without departing from the spirit and principle of embodiments of this application shall fall within the protection scope of embodiments of this application.

## Claims

1. A data compression method, wherein the method comprises:
obtaining a to-be-compressed data stream, wherein the data stream comprises a plurality of pieces of data;
determining a plurality of types of data from the plurality of pieces of data based on context information of each of the plurality of pieces of data, wherein each of the plurality of types of data comprises at least one of the plurality of pieces of data, and the context information of each piece of data indicates data before and/or after corresponding data in the data stream; and
compressing at least one of the plurality of types of data.

2. The method according to claim 1, wherein determining the plurality of types of data from the plurality of pieces of data based on the context information of each of the plurality of pieces of data comprises:
determining at least one piece of first data in the plurality of pieces of data, wherein the first data is data that appears for the non-first time in the data stream, and using each piece of first data as one type of same data; and
classifying at least one piece of second data other than the at least one piece of first data in the plurality of pieces of data based on a similarity, to obtain at least one type of similar data.

3. The method according to claim 2, wherein compressing the at least one of the plurality of types of data comprises:
for each piece of first data, determining a repeated appearance rule of each piece of first data as compressed data of corresponding first data, wherein the repeated appearance rule indicates an association between the corresponding first data and third data, and the third data is data that is in the data stream and that precedes the first data and that is the same as the first data; and
for any of the at least one type of similar data, if the any type of similar data comprises a plurality of pieces of second data, determining a compression algorithm corresponding to the any type of similar data, and compressing the any type of similar data according to the compression algorithm corresponding to the any type of similar data, to obtain compressed data corresponding to each piece of second data in the any type of similar data.

4. The method according to claim 2 or 3, wherein determining the at least one piece of first data in the plurality of pieces of data comprises:
sequentially inputting the plurality of pieces of data to each of at least one predictor, wherein each predictor is configured to predict a predicted value of currently input data based on data input before current time; and
for an i^{th} piece of data in the plurality of pieces of data, if a difference between a predicted value output by a first predictor in the at least one predictor and the i^{th} piece of data is 0, determining the i^{th} piece of data as one piece of first data.

5. The method according to claim 4, wherein compressing the at least one of the plurality of types of data comprises:
determining an identifier of the first predictor as compressed data of the i^{th} piece of data.

6. The method according to claim 4 or 5, wherein the method further comprises:
if a difference between a predicted value output by each of the at least one predictor and the i^{th} piece of data is not 0, searching each of at least one hash table for data the same as the i^{th} piece of data; and
if a first hash table in the at least one hash table stores the data the same as the i^{th} piece of data, determining the i^{th} piece of data as one piece of first data.

7. The method according to claim 6, wherein compressing the at least one of the plurality of types of data comprises:
determining an identifier of the first hash table and a hash value of the i^{th} piece of data in the first hash table as compressed data of the i^{th} piece of data.

8. The method according to any one of claims 4 to 7, wherein the method further comprises:
if the difference between the predicted value output by each of the at least one predictor and the i^{th} piece of data is not 0, updating the at least one predictor, wherein a difference between a predicted value output by a second predictor in at least one updated predictor and the i^{th} piece of data is 0.

9. The method according to any one of claims 6 to 8, wherein the method further comprises:
if there is no data the same as the i^{th} piece of data in the at least one hash table, updating the at least one hash table, wherein a second hash table in at least one updated hash table stores the data the same as the i^{th} piece of data.

10. The method according to any one of claims 6 to 9, wherein the method further comprises:
if there is no data the same as the i^{th} piece of data in the at least one hash table, generating label information of the i^{th} piece of data, wherein the label information indicates that the i^{th} piece of data is one piece of second data.

11. The method according to any one of claims 2 to 10, wherein
for the any of the at least one type of similar data, a distance between any two pieces of data in the any type of similar data is less than a reference distance.

12. A data compression apparatus, wherein the apparatus comprises:
an obtaining module, configured to obtain a to-be-compressed data stream, wherein the data stream comprises a plurality of pieces of data;
a determining module, configured to determine a plurality of types of data from the plurality of pieces of data based on context information of each of the plurality of pieces of data, wherein each of the plurality of types of data comprises at least one of the plurality of pieces of data, and the context information of each piece of data indicates data before and/or after corresponding data in the data stream; and
a compression module, configured to compress at least one of the plurality of types of data.

13. The apparatus according to claim 12, wherein the determining module comprises:
a determining submodule, configured to: determine at least one piece of first data in the plurality of pieces of data, wherein the first data is data that appears for the non-first time in the data stream, and use each piece of first data as one type of same data; and
a classification submodule, configured to classify at least one piece of second data other than the at least one piece of first data in the plurality of pieces of data based on a similarity, to obtain at least one type of similar data.

14. The apparatus according to claim 13, wherein the compression module is configured to:
for each piece of first data, determine a repeated appearance rule of each piece of first data as compressed data of corresponding first data, wherein the repeated appearance rule indicates an association between the corresponding first data and third data, and the third data is data that is in the data stream and that precedes the first data and that is the same as the first data; and
for any of the at least one type of similar data, if the any type of similar data comprises a plurality of pieces of second data, determine a compression algorithm corresponding to the any type of similar data, and compress the any type of similar data according to the compression algorithm corresponding to the any type of similar data, to obtain compressed data corresponding to each piece of second data in the any type of similar data.

15. The apparatus according to claim 13 or 14, wherein the determining submodule is configured to:
sequentially input the plurality of pieces of data to each of at least one predictor, wherein each predictor is configured to predict a predicted value of currently input data based on data input before current time; and
for an i^{th} piece of data in the plurality of pieces of data, if a difference between a predicted value output by a first predictor in the at least one predictor and the i^{th} piece of data is 0, determine the i^{th} piece of data as one piece of first data.

16. The apparatus according to claim 15, wherein the compression module is configured to:
determine an identifier of the first predictor as compressed data of the i^{th} piece of data.

17. The apparatus according to claim 15 or 16, wherein the determining submodule is further configured to:
if a difference between a predicted value output by each of the at least one predictor and the i^{th} piece of data is not 0, search each of at least one hash table for data the same as the i^{th} piece of data; and
if a first hash table in the at least one hash table stores the data the same as the i^{th} piece of data, determine the i^{th} piece of data as one piece of first data.

18. The apparatus according to claim 17, wherein the compression module is configured to:
determine an identifier of the first hash table and a hash value of the i^{th} piece of data in the first hash table as compressed data of the i^{th} piece of data.

19. The apparatus according to any one of claims 15 to 18, wherein the apparatus further comprises:
a first update module, configured to: if the difference between the predicted value output by each of the at least one predictor and the i^{th} piece of data is not 0, update the at least one predictor, wherein a difference between a predicted value output by a second predictor in at least one updated predictor and the i^{th} piece of data is 0.

20. The apparatus according to any one of claims 17 to 19, wherein the apparatus further comprises:
a second update module, configured to: if there is no data the same as the i^{th} piece of data in the at least one hash table, update the at least one hash table, wherein a second hash table in at least one updated hash table stores the data the same as the i^{th} piece of data.

21. The apparatus according to any one of claims 17 to 20, wherein the apparatus further comprises:
a generation module, configured to: if there is no data the same as the i^{th} piece of data in the at least one hash table, generate label information of the i^{th} piece of data, wherein the label information indicates that the i^{th} piece of data is one piece of second data.

22. The apparatus according to any one of claims 13 to 21, wherein
for the any of the at least one type of similar data, a distance between any two pieces of data in the any type of similar data is less than a reference distance.

23. A computer device, wherein the computer device comprises a memory and a processor;
the memory is configured to: store a program that supports the computer device in performing the method according to any one of claims 1 to 11, and store data used to implement the method according to any one of claims 1 to 11; and
the processor is configured to execute the program stored in the memory.

24. A computer-readable storage medium, wherein the computer-readable storage medium stores instructions, and when the instructions are run on a computer, the computer is enabled to perform the method according to any one of claims 1 to 11.
